Europäisches Patentamt

European Patent Office

Office européen des brevets

(19)

(11) **EP 1 560 220 A1**

(12) # DEMANDE DE BREVET EUROPEEN

(43) Date de publication:
**03.08.2005 Bulletin 2005/31**

(51) Int Cl.⁷: **G11C 5/14**, G11C 7/22,
G06F 1/32

(21) Numéro de dépôt: **04106884.2**

(22) Date de dépôt: **22.12.2004**

(84) Etats contractants désignés:
**AT BE BG CH CY CZ DE DK EE ES FI FR GB GR
HU IE IS IT LI LT LU MC NL PL PT RO SE SI SK TR**
Etats d'extension désignés:
**AL BA HR LV MK YU**

(30) Priorité: **24.12.2003 FR 0351194**

(71) Demandeur: **DOLPHIN INTEGRATION
F-38240 Meylan (FR)**

(72) Inventeurs:
• **BONZO, Andrea
38190, FROGES (FR)**
• **POLLET, Jean-François
38560, JARRIE (FR)**

(74) Mandataire: **de Beaumont, Michel et al
Cabinet Michel de Beaumont
1, rue Champollion
38000 Grenoble (FR)**

(54) **Circuit intégré à mémoire à consommation réduite**

(57)     L'invention concerne un circuit intégré (10) comportant des éléments de mémoire volatile (20, 50), des circuits d'interface (22, 52) reliés aux éléments de mémoire volatile et, éventuellement, des circuits logiques (54) non reliés aux éléments de mémoire volatile et comprenant des première, deuxième, et éventuelle- ment troisième alimentations distinctes (Vdd_M, Vdd_I, Vdd_L), la première alimentation étant connectée aux éléments de mémoire volatile, la deuxième alimentation étant connectée aux circuits d'interface avec les élé- ments de mémoire et la troisième alimentation étant connectée à d'autres circuits logiques.

Fig 3

**Description**

La présente invention concerne les circuits intégrés comportant des éléments de mémoire volatile et des circuits logiques associés aux éléments de mémoire volatile, notamment des éléments de mémoire volatile comportant des éléments logiques ou analogiques.

Une mémoire de circuit intégré peut être composée d'un ensemble d'éléments de mémoire, ou cellules mémoire, éventuellement disposés selon une matrice. L'écriture et la lecture de données dans les éléments de mémoire sont réalisées au moyen de circuits logiques dédiés. Une alimentation fournit généralement l'énergie nécessaire au bon fonctionnement des composants des éléments de mémoire et des circuits logiques. L'alimentation de la mémoire est généralement obtenue par un ou plusieurs rails connectés à l'ensemble des cellules mémoire et des circuits logiques et transportant une tension d'alimentation. Une mémoire est dite volatile dans le cas où les données stockées dans les éléments de mémoire volatile risquent d'être perdues lorsque l'alimentation de la mémoire passe en dessous d'un seuil minimal. A l'inverse, une mémoire est dite non volatile lorsque les données mémorisées dans la mémoire sont conservées même lors de l'extinction de l'alimentation de la mémoire.

Dans le cas d'une mémoire volatile, si l'on souhaite conserver les données même lorsque le circuit intégré n'est pas utilisé, l'alimentation de la mémoire doit être maintenue en permanence à un niveau supérieur au seuil minimal de non perte de données, ce qui correspond à un mode de fonctionnement dit inactif ou mode de veille. Ceci entraîne donc une consommation du circuit intégré en mode inactif, appelé consommation statique.

Pour certaines applications, la consommation du circuit intégré est un facteur critique. Il s'agit par exemple des circuits intégrés équipant un téléphone cellulaire alimentés par les batteries du téléphone. En effet, les batteries d'un téléphone cellulaire ayant une capacité limitée, on cherche à réduire au maximum la consommation du circuit intégré, en particulier en mode inactif qui peut correspondre à un mode où le téléphone est complètement éteint ou à un mode où le circuit intégré n'est pas sollicité ou à un mode où la mémoire volatile ou les mémoires volatiles ne sont pas sollicitées.

La présente invention prévoit un circuit intégré comportant des éléments de mémoire volatile et des circuits logiques permettant de réduire la consommation du circuit intégré en mode inactif tout en assurant la conservation des données mémorisées dans les éléments de mémoire volatile.

Pour atteindre cet objet, la présente invention prévoit un circuit intégré comportant des éléments de mémoire volatile et des circuits logiques d'interface reliés aux éléments de mémoire volatile, et comprenant des première et deuxième alimentations distinctes, la première alimentation étant connectée aux éléments de mémoire volatile et la deuxième alimentation étant connectée aux circuits logiques d'interface.

Selon un mode de réalisation de l'invention, le circuit comprend des moyens pour éteindre la deuxième alimentation et pour mettre la première alimentation à un niveau minimal non nul adapté à assurer la conservation des informations stockées dans les éléments de mémoire volatile, dans un mode de fonctionnement déterminé.

Selon un mode de réalisation de l'invention, les éléments de mémoire volatile comprennent des transistors MOS d'un premier type, et les circuits logiques d'interface comprennent des transistors MOS d'un deuxième type, les transistors du premier type ayant une épaisseur d'oxyde de grille supérieure à l'épaisseur d'oxyde de grille des transistors du deuxième type ou les transistors du premier type ayant chacun une zone active de canal dopée pour fournir des courants de fuite plus faibles que pour les transistors du deuxième type.

Selon un mode de réalisation de l'invention, le circuit comprend des moyens pour mettre les première et deuxième alimentations à des niveaux non nuls dans un mode de fonctionnement déterminé, la première alimentation étant à un niveau différent du niveau de la deuxième alimentation.

Selon un mode de réalisation de l'invention, le circuit comprend des circuits logiques supplémentaires, et une troisième alimentation, distincte des première et deuxième alimentations, connectée aux circuits logiques supplémentaires.

Selon un mode de réalisation de l'invention, le circuit comprend des moyens pour éteindre la troisième alimentation et maintenir les première et deuxième alimentations à un niveau non nul dans un mode de fonctionnement déterminé.

Selon un mode de réalisation de l'invention, le circuit comprend des moyens pour éteindre les deuxième et troisième alimentations et mettre la première alimentation à un niveau minimal non nul adapté à assurer la conservation des informations stockées dans les éléments de mémoire volatile dans un mode de fonctionnement déterminé.

Selon un mode de réalisation de l'invention, les circuits logiques supplémentaires comprennent des transistors d'un troisième type, les transistors du premier type ayant une épaisseur d'oxyde de grille supérieure à l'épaisseur d'oxyde de grille des transistors du troisième type ou les transistors du premier type ayant chacun une zone active de canal dopée pour fournir des courants de fuite plus faibles que pour les transistors du troisième type, les transistors du troisième type ayant une vitesse de commutation supérieure à la vitesse de commutation des transistors du deuxième type.

Selon un mode de réalisation de l'invention, le circuit comprend des moyens pour mettre les première, deuxième et troisième alimentations à des niveaux différents.

La présente invention prévoit également un procédé de commande en mode de veille d'un circuit intégré comprenant des éléments de mémoire volatile et des circuits logiques d'interface reliés aux éléments de mémoire volatile, le procédé comprenant les étapes suivantes consistant à prévoir une première alimentation connectée aux éléments de mémoire volatile ; à prévoir une deuxième alimentation, distincte de la première alimentation, connectée aux circuits logiques d'interface ; et à éteindre la deuxième alimentation et mettre la première alimentation à un niveau minimal non nul adapté à assurer la conservation des informations stockées dans les éléments de mémoire volatile.

Cet objet, ces caractéristiques et avantages, ainsi que d'autres de la présente invention seront exposés en détail dans la description suivante de modes de réalisation particuliers faite à titre non-limitatif en relation avec les figures jointes parmi lesquelles :

> la figure 1 représente, de façon schématique, une mémoire volatile d'un circuit intégré selon l'invention ;
> la figure 2 représente un exemple de réalisation plus détaillé d'un élément de la mémoire volatile de la figure 1 et des circuits logiques associés ; et
> la figure 3 représente un autre exemple de réalisation de circuit intégré selon l'invention.

De façon générale, la présente invention prévoit de séparer l'alimentation des éléments de mémoire volatile de l'alimentation des autres éléments du circuit intégré. Comme cela est décrit plus en détail par la suite, en faisant varier différemment les niveaux des alimentations en mode inactif, on peut diminuer la consommation statique du circuit intégré. De plus, la séparation des alimentations permet d'utiliser des transistors d'un type donné pour les éléments de mémoire volatile et des transistors d'un type différent pour les autres éléments du circuit intégré. Une telle séparation des alimentations peut être poursuivie au niveau des éléments autres que les éléments de mémoire volatile comme cela sera illustré par la suite. On peut prévoir, par exemple, des alimentations séparées pour les circuits logiques en interface avec les éléments de mémoire volatile et les autres circuits logiques du circuit intégré.

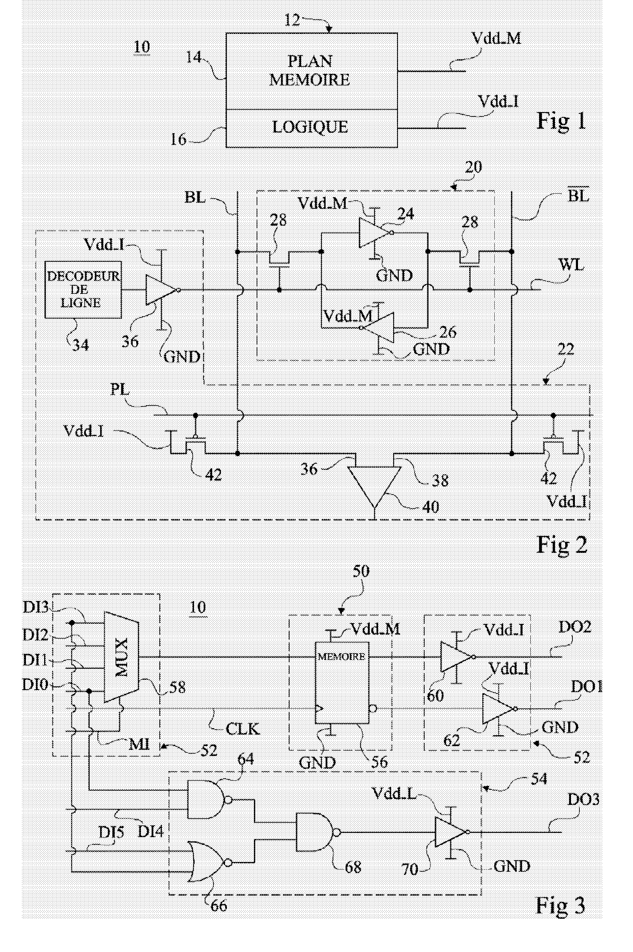

Comme cela est représenté en figure 1, un circuit intégré 10 selon l'invention contient une mémoire volatile 12 qui est représentée, à des fins d'illustration, par un plan mémoire 14 et un circuit logique d'interface 16. Le plan mémoire 14 est par exemple constitué d'une matrice d'éléments de mémoire volatile. Le circuit logique d'interface 16 comprend l'ensemble des composants adaptés à adresser les éléments de mémoire volatile pour écrire ou lire des données dans les éléments de mémoire volatile. Selon l'invention, la mémoire 12 est connectée à deux alimentations distinctes. Dans le présent exemple, une alimentation correspond à une tension d'alimentation ou au couple formé par une tension d'alimentation et une tension de référence, couramment la masse GND. Une première tension d'alimentation Vdd_M est fournie au plan mémoire 14 et une seconde tension d'alimentation Vdd_I est fournie au circuit logique d'interface 16. Les tensions d'alimentation Vdd_M et Vdd_I peuvent être commandées de façon indépendante et, en particulier, être fixées à des valeurs différentes.

La figure 2 représente de façon plus détaillée un élément de mémoire volatile 20 du plan mémoire 14 de la figure 1 et des composants 22 du circuit logique d'interface 16 utilisés pour l'écriture et/ou la lecture de données dans l'élément de mémoire volatile 20. L'élément de mémoire volatile 20 représenté est un élément d'une mémoire statique du type à accès aléatoire (SRAM) et comprend des inverseurs 24, 26 connectés en antiparallèle. Les entrées respectives des inverseurs 24, 26, sont reliées à des lignes de bits respectives **BL,** $\overline{\textbf{BL}}$**,** par l'intermédiaire d'interrupteurs 28 commandés par un signal de sélection de rangées transporté par une ligne de mots WL. Chaque inverseur 24, 26 est alimenté par une tension haute Vdd_M et la tension de référence GND. Un élément de mémoire volatile 20 peut être constitué de six transistors MOS, chaque inverseur 24, 26 comprenant deux transistors MOS complémentaires.

Les composants 22 du circuit logique d'interface 16 comprennent un décodeur de lignes 32 relié à un inverseur 34 qui fournit le signal de sélection de rangées transporté par la ligne de mots WL. Les lignes de bits **BL** et $\overline{\textbf{BL}}$ constituent les entrées 36, 38 d'un amplificateur de lecture 40. Les entrées 36, 38 de l'amplificateur 40 sont reliées à la tension Vdd_I par l'intermédiaire de transistors de précharge 42 commandés par un signal de précharge transporté par une ligne de précharge PL.

Pour écrire une information dans l'élément de mémoire 20, on applique par exemple sur l'une des lignes de bits **BL** ou $\overline{\textbf{BL}}$ la tension Vdd_M et sur l'autre la tension GND. Les interrupteurs 28 sont alors fermés pour fixer l'état des entrées et des sorties des inverseurs 24, 26. Les interrupteurs 28 sont ensuite ouverts et l'état des signaux aux bornes des inverseurs 24, 26 se maintient.

Pour lire une information dans l'élément de mémoire, chaque ligne de bits **BL** et $\overline{\textbf{BL}}$ est, par exemple, préchargée à une tension comprise entre les tensions Vdd_M et GND, puis les interrupteurs 28 sont fermés de manière que les tensions sur les lignes de bits varient en fonction de l'état des signaux aux bornes des inverseurs 24, 26. L'amplificateur de lecture 40 fournit une information binaire en rapport avec l'information conservée dans l'élément de mémoire volatile 20.

La présente invention prévoit une commande indépendante des tensions d'alimentation Vdd_M et Vdd_I. En fonctionnement normal, ou mode actif, les tensions d'alimentation Vdd_M et Vdd_I ont chacune un niveau nominal. En mode inactif, qui correspond dans le présent exemple à un fonctionnement du circuit intégré dans lequel la mémoire 12 n'est pas sollicitée, l'alimentation du circuit logique d'interface 16 peut être interrompue, ce qui correspond à une mise à zéro de la tension Vdd_I. L'alimentation du plan mémoire 14 n'est pas interrompue pour ne pas perdre les informations mémorisées dans le plan mémoire 14. Toutefois, la tension d'alimentation Vdd_M peut être diminuée par rapport au niveau actif jusqu'à un niveau minimum de non perte d'informations.

On obtient donc une diminution de la consommation statique de la mémoire 12 puisqu'il n'y a plus de pertes au niveau du circuit logique d'interface 16 en mode inactif.

Les tensions d'alimentation Vdd_M et Vdd_I du plan mémoire 12 et du circuit logique d'interface 16 pouvant être de niveaux différents, la présente invention permet d'utiliser des transistors MOS de types différents pour les éléments de mémoire volatile 20 du plan mémoire 14 et pour le circuit logique d'interface 16. En effet, en fonction des technologies de fabrication de transistors MOS envisagées, différents types de transistors sont généralement proposés aux concepteurs de circuits intégrés selon qu'ils privilégient une vitesse de commutation de transistor élevée ou des faibles courants de fuite. A titre d'exemple, il existe généralement dans toutes les technologies de fabrication de transistors MOS, des transistors appelés transistors d'interface ou transistors haute tension, qui ont une épaisseur d'oxyde de grille plus importante que l'épaisseur d'oxyde de grille des autres transistors fabriqués selon la même technologie, et appelés par la suite transistors à grille mince. Les tensions appliquées entre la source et le drain sont généralement plus élevées pour les transistors haute tension que pour les transistors à grille mince. En outre, les transistors haute tension sont généralement commandés par des tensions de grille supérieures aux tensions utilisées avec des transistors MOS à grille mince. Les courants de fuite qui apparaissent avec un transistor haute tension sont moins importants que pour un transistor à grille mince. Toutefois, la vitesse de commutation d'un transistor haute tension est généralement moins élevée que celle d'un transistor à grille mince. Généralement, on utilise des transistors à grille mince pour la réalisation des circuits logiques et des mémoires d'un circuit intégré. Les transistors haute tension sont habituellement utilisés pour réaliser l'interface entre les parties numériques et analogiques d'un circuit intégré.

A titre d'exemple, dans le cas d'une filière technologique MOS à 0,13 micromètres, quatre types de transistor différents sont généralement disponibles dont trois types ont la même épaisseur d'oxyde de grille et ont des dopages différents de la région active de canal selon que l'on privilégie une augmentation de la vitesse de commutation ou une diminution des courants de fuite. Le quatrième type correspond au transistor haute tension qui a une épaisseur de grille plus élevée.

Selon la présente invention, on utilise des transistors haute tension pour la réalisation des éléments de mémoire volatile 20 du plan mémoire 14. On privilégie ainsi la diminution des courants de fuite au niveau du plan mémoire 14. On maintient par ailleurs l'utilisation de transistors à grille mince, plus rapides, pour le circuit logique d'interface 16. On considère que la perte de vitesse de commutation en raison de l'utilisation de transistors haute tension n'est pas préjudiciable au fonctionnement global de la mémoire 12. Pour optimiser les performances dynamiques des transistors haute tension, la tension Vdd_M est néanmoins choisie supérieure à la tension Vdd_I en mode actif. Le circuit logique d'interface 16 est donc constitué de transistors rapides alimentés par une tension d'alimentation Vdd_I qui est coupée en mode inactif.

L'utilisation de transistors haute tension permet donc une diminution supplémentaire de la consommation de la mémoire 12, obtenue à la fois en mode actif et en mode inactif. En effet, la demanderesse a mis en évidence que même lorsque la tension d'alimentation Vdd_M ne varie pas entre le mode actif et le mode inactif et que la tension d'alimentation Vdd_I varie entre une valeur nominale en mode actif et la valeur nulle en mode inactif, on obtient une réduction de la consommation de la mémoire 12 par rapport à une structure analogue dans laquelle seuls des transistors à grille mince sont utilisés.

De préférence, comme cela a été décrit précédemment, il est avantageux de diminuer la tension d'alimentation Vdd_M en mode inactif pour réduire au maximum la consommation statique de la mémoire 12. A titre d'exemple, pour une technologie à 0,18 micromètres, on peut utiliser une tension d'alimentation Vdd_M sensiblement égale à 3,3 volts en mode actif et à 0,9 volts en mode inactif et une tension d'alimentation Vdd_I sensiblement égale à 1,8 volts en mode actif et sensiblement nulle en mode inactif.

Toutefois, pour certaines applications, il peut être préférable de maintenir la tension d'alimentation Vdd_M à un niveau élevé même en mode inactif. En effet, notamment pour des applications en téléphonie cellulaire, on prévoit généralement une seule batterie qui fournit en mode actif directement la tension d'alimentation Vdd_M et qui est reliée à un régulateur abaisseur de tension pour fournir la tension d'alimentation Vdd_I. En mode inactif, pour fournir une tension d'alimentation Vdd_M diminuée, il serait nécessaire d'utiliser un régulateur abaisseur de tension dont le fonctionnement entraînerait une surconsommation plus importante que les gains de consommation obtenus en diminuant la tension d'alimentation Vdd_M.

La figure 3 représente un autre exemple de réalisation de l'invention dans lequel le circuit intégré 10 comprend un élément de mémoire volatile 50, des circuits d'interface 52 connectés à l'élément de mémoire volatile 50, et un circuit logique 54 effectuant des opérations logiques sans relation directe avec le fonctionnement de l'élément de mémoire volatile 50. A titre d'exemple, l'élément de mémoire volatile 50 est constitué d'une bascule 56 commandée par un signal d'horloge CLK. Les circuits d'interface 52 comprennent un multiplexeur 58 comportant quatre entrées DIO, DI1, DI2 et DI3, recevant un signal de sélection MI, et fournissant l'un des signaux d'entrée DIO à DI3 à la bascule 56. Les circuits d'interface 52 comprennent deux inverseurs 60, 62 recevant deux signaux de sortie complémentaires fournis par la bascule 56. Les inverseurs 60, 62 fournissent des données de sortie DO1 et DO2. Le circuit logique 54 comprend une porte logique NON ET 64 recevant les signaux DI0 et DI4 et une porte logique NON OU 66 recevant le signal DI3 et un signal d'entrée DI5. Une porte logique NON ET 68 reçoit les sorties des portes logiques 64, 66. La sortie de la porte logique 68 est fournie à un inverseur 70 qui fournit un signal de sortie DO3.

Dans le présent exemple de réalisation, on prévoit trois alimentations distinctes, Vdd_M, Vdd_I et Vdd_L, respectivement pour l'élément de mémoire volatile 50, les circuits d'interface 52 et le circuit logique 54. On diminue la consommation statique du circuit intégré 10 en mode inactif, en mettant à zéro les tensions d'alimentation Vdd_I et Vdd_L des circuits d'interface 52 et du circuit logique 54 et en maintenant la tension d'alimentation Vdd_M égale à une tension minimale de non perte d'information pour l'élément de mémoire volatile 50.

En outre, selon le présent exemple de l'invention, on peut utiliser trois types de transistors différents. Des transistors haute tension entraînant de faibles courants de fuite sont utilisés pour l'élément de mémoire volatile 50. Des transistors à grille mince sont utilisés pour les circuits d'interface 52 et le circuit logique 54. Par exemple, selon le but recherché, on privilégiera l'utilisation de transistors à grille mince ayant une vitesse de commutation élevée pour le circuit logique 54 et des transistors à grille mince et à faible courant de fuite pour les circuits d'interface 52. Les trois alimentations distinctes Vdd_M, Vdd_I et Vdd_L sont donc associées chacune à une famille de transistors particuliers.

Le niveau de chaque alimentation peut être modifié de façon indépendante. Un exemple de séquencement est le suivant :

a. En mode actif, les trois tensions d'alimentation sont mises à une valeur nominale. La tension d'alimentation Vdd_M est supérieure à la tension d'alimentation Vdd_I, elle-même supérieure à la tension d'alimentation Vdd_L qui est supérieure à zéro. Les performances de vitesse du circuit intégré 10 qui dépendent essentiellement des performances de vitesse du circuit logique 54 sont alors optimisées.
b. En mode dégradé, seules les tensions d'alimentation Vdd_M et Vdd_I sont à la valeur nominale. La tension d'alimentation Vdd_L est mise à zéro. Un tel mode correspond par exemple au cas où seules certaines fonctions du circuit intégré 10 mettant en oeuvre l'élément de mémoire volatile 50 doivent être maintenues. Pour une application en téléphonie cellulaire, il peut s'agir d'un cas où l'on consulte un numéro stocké dans une mémoire du portable, opération qui ne nécessite pas la totalité des ressources de calcul du téléphone. Les transistors utilisés pour les circuits d'interface 52 étant définis pour limiter les courants de fuite, on réduit alors la consommation globale du circuit intégré 10.
c. En mode inactif, seule la tension d'alimentation Vdd_M est différente de zéro. Les tensions d'alimentation Vdd_I et Vdd_L sont mises à zéro. On assure alors une consommation statique minimale.

Selon une variante de la présente invention, le circuit intégré peut comprendre des éléments de mémoire non volatile et une alimentation reliée aux éléments de mémoire non volatile distincte de l'alimentation des éléments de mémoire volatile. Il s'agit par exemple de la même alimentation reliée aux circuits logiques en interface avec la mémoire volatile. L'alimentation reliée aux éléments de mémoire non volatile est alors éteinte en mode inactif.

Dans les exemples de réalisation précédemment décrits, les éléments de mémoire volatile sont des éléments de mémoire volatile logiques. Il est clair que les éléments de mémoire volatile peuvent être des éléments de mémoire volatile analogique et les circuits associés indifféremment de type logique ou analogique.

Dans les exemples de réalisation précédemment décrits, les circuits d'interface reliés aux éléments de mémoire volatile sont des circuits d'interface logiques. Il est clair que les circuits d'interface peuvent être des circuits d'interface analogiques ou des circuits d'interface mixtes analogiques et numériques.

Dans l'exemple de réalisation représenté en figure 3, il est décrit trois alimentations distinctes, Vdd_M, Vdd_I et Vdd_L, respectivement pour l'élément de mémoire volatile 50, les circuits d'interface 52 et le circuit logique 54. Il est clair qu'un nombre plus important d'alimentations distinctes peut être prévu. Par exemple, dans le cas où différents circuits logiques autres que le circuit d'interface sont présents, plusieurs alimentations distinctes, commandables de façon indépendante (en plus des alimentations prévues pour l'élément de mémoire volatile et les circuits d'interface) peuvent être utilisées pour l'alimentation de tels circuits logiques.

La présente invention comporte de nombreux avantages :

premièrement, elle permet une amélioration des performances en terme de consommation au moins en mode inactif selon un gain pouvant atteindre et dépasser le millier ;
deuxièmement, par le choix de transistors et de niveaux d'alimentation appropriés, elle permet d'améliorer les performances du circuit intégré en terme de consommation en mode actif et inactif ; et

troisièmement, par le choix de transistors et de tensions d'alimentation appropriés, elle permet d'accélérer les performances de vitesse des circuits logiques qui le nécessitent.

Bien entendu, la présente invention est susceptible de diverses variantes et modifications qui apparaîtront à l'homme de l'art. En particulier, les alimentations peuvent consister en des sources de courant réglables. En outre, dans les exemples précédemment décrits, la tension de référence est la même pour la mémoire volatile, le circuit logique d'interface et le circuit logique 54. Ceci n'est pas une condition nécessaire et la mémoire volatile, le circuit logique d'interface et le circuit logique 54 peuvent être reliés à des tensions de référence différentes.

**Revendications**

1. Circuit intégré (10) comportant des éléments de mémoire volatile (20, 50) et des circuits d'interface (16, 22, 52) reliés aux éléments de mémoire volatile, comprenant des première et deuxième alimentations distinctes (Vdd_M, Vdd_I), la première alimentation étant connectée aux éléments de mémoire volatile et la deuxième alimentation étant connectée aux circuits d'interface et dans lequel les éléments de mémoire volatile (20, 50) comprennent des transistors MOS (28) d'un premier type, et les circuits d'interface (22, 52, 54) comprennent des transistors MOS (42) d'un deuxième type différent du premier type.

2. Circuit intégré selon la revendication 1, comprenant des moyens pour éteindre la deuxième alimentation (Vdd_I) et pour mettre la première alimentation (Vdd_M) à un niveau minimal non nul adapté à assurer la conservation des informations stockées dans les éléments de mémoire volatile (20, 50), dans un mode de fonctionnement déterminé.

3. Circuit intégré selon la revendication 1, dans lequel les transistors du premier type ont une épaisseur d'oxyde de grille supérieure à l'épaisseur d'oxyde de grille des transistors du deuxième type ou les transistors du premier type ont chacun une zone active de canal dopée pour fournir des courants de fuite plus faibles que pour les transistors du deuxième type.

4. Circuit intégré selon la revendication 3, comprenant des moyens pour mettre les première et deuxième alimentations (Vdd_M, Vdd_I) à des niveaux non nuls dans un mode de fonctionnement déterminé, la première alimentation (Vdd_M) étant à un niveau différent du niveau de la deuxième alimentation (Vdd_I).

5. Circuit intégré selon la revendication 1, comprenant des circuits logiques supplémentaires (54), et une troisième alimentation (Vdd_L), distincte des première et deuxième alimentations (Vdd_M, Vdd_I), connectée aux circuits logiques supplémentaires.

6. Circuit intégré selon la revendication 5, comprenant des moyens pour éteindre la troisième alimentation (Vdd_L) et maintenir les première et deuxième alimentations (Vdd_M, Vdd_I) à un niveau non nul dans un mode de fonctionnement déterminé.

7. Circuit intégré selon la revendication 5, comprenant des moyens pour éteindre les deuxième et troisième alimentations (Vdd_I, Vdd_L) et mettre la première alimentation (Vdd_M) à un niveau minimal non nul adapté à assurer la conservation des informations stockées dans les éléments de mémoire volatile (20, 50) dans un mode de fonctionnement déterminé.

8. Circuit intégré selon les revendications 3 et 5, dans lequel les circuits logiques supplémentaires (54) comprennent des transistors d'un troisième type, les transistors du premier type ayant une épaisseur d'oxyde de grille supérieure à l'épaisseur d'oxyde de grille des transistors du troisième type ou les transistors du premier type ayant chacun une zone active de canal dopée pour fournir des courants de fuite plus faibles que pour les transistors du troisième type, les transistors du troisième type ayant une vitesse de commutation supérieure à la vitesse de commutation des transistors du deuxième type.

9. Circuit intégré selon la revendication 8, comprenant des moyens pour mettre les première, deuxième et troisième alimentations (Vdd_M, Vdd_I, Vdd_L) à des niveaux différents.

10. Procédé de commande en mode de veille d'un circuit intégré (10) comprenant des éléments de mémoire volatile (20, 50) et des circuits d'interface (16, 22, 52) reliés aux éléments de mémoire volatile, **caractérisé en ce qu'**il comprend les étapes suivantes :

   prévoir une première alimentation (Vdd_M) connectée aux éléments de mémoire volatile ;
   prévoir une deuxième alimentation (Vdd_I), distincte de la première alimentation, connectée aux circuits d'interface ;
   prévoir, pour les éléments de mémoire volatile (20, 50), des transistors MOS (28) d'un premier type, et, pour les circuits d'interface (22, 52, 54), des transistors MOS (42) d'un deuxième type différent du premier type ; et
   éteindre la deuxième alimentation et mettre la première alimentation à un niveau minimal non nul adapté à assurer la conservation des informations stockées dans les éléments de mémoire volatile (20, 50).

10

12

14 PLAN MEMOIRE Vdd_M

16 LOGIQUE Vdd_I

Fig 1

20

BL $\overline{BL}$

Vdd_M 24 28

28

DECODEUR DE LIGNE Vdd_I GND

GND

Vdd_M 26

GND

34 36 GND

WL

PL 22

Vdd_I 42 36 38 42 Vdd_I

40

Fig 2

50

DI3 10 Vdd_M Vdd_I DO2

DI2 MUX MEMOIRE Vdd_I

DI1 DO1

DI0 58 60 62 GND

MI 52 CLK GND 56 52

64 54

DI5 DI4 Vdd_L DO3

68 70 GND

66

Fig 3

Office européen
des brevets

**RAPPORT DE RECHERCHE EUROPEENNE**

Numéro de la demande

EP 04 10 6884

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 2003/218915 A1 (ISONO TAKANORI) 27 novembre 2003 (2003-11-27) | 10 | G11C5/14 G11C7/22 |
| A | * alinéas [0005] - [0007], [0039]; figure 8 * | 1-9 | G06F1/32 |
| | ----- | | |
| A | US 5 740 118 A (SATO HAJIME ET AL) 14 avril 1998 (1998-04-14) * colonne 5, ligne 48 - colonne 6, ligne 35 * | 1-10 | |
| | ----- | | |
| A | US 5 726 562 A (MIZUNO MASAYUKI) 10 mars 1998 (1998-03-10) * le document en entier * | 1-10 | |
| | ----- | | |

**DOMAINES TECHNIQUES RECHERCHES (Int.Cl.7)**

G11C
G06F

Le présent rapport a été établi pour toutes les revendications

| Lieu de la recherche | Date d'achèvement de la recherche | Examinateur |
|---|---|---|
| La Haye | 27 mai 2005 | Czarik, D |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 10 6884

La présente annexe indique les membres de la  famille de brevets relatifs aux documents  brevets cités dans le rapport de recherche européenne visé ci-dessus.
Lesdits members sont contenus au fichier informatique de l'Office  européen des brevets à la date du
Les renseignements fournis sont donnés à titre  indicatif et n'engagent pas la responsabilité  de l'Office européen des brevets.

27-05-2005

| Document brevet cité au rapport de recherche | | Date de publication | Membre(s) de la famille de brevet(s) | | Date de publication |
|---|---|---|---|---|---|
| US 2003218915 | A1 | 27-11-2003 | JP 2003347917 A<br>CN 1461108 A | | 05-12-2003<br>10-12-2003 |
| US 5740118 | A | 14-04-1998 | JP 9147553 A<br>KR 226085 B1 | | 06-06-1997<br>15-10-1999 |
| US 5726562 | A | 10-03-1998 | JP 9073784 A<br>KR 242782 B1 | | 18-03-1997<br>01-02-2000 |

EPO FORM P0460

Pour tout renseignement concernant cette annexe :  voir Journal Officiel de l'Office européen des  brevets, No.12/82